# EUROPEAN PATENT APPLICATION

(11) **EP 0 752 719 A1**
(43) Date of publication of application: **08.01.1997**
(21) Application number: 96304139.7
(22) Date of filing: 05.06.1996
(51) Int. Cl.: H01L 21/86, H01L 21/20, H01L 21/336, H01L 29/786

(54) **Method of manufacturing a silicon on sapphire integrated circuit arrangement**

(30) Priority: 07.07.1995 GB 9513909
(71) Applicant: PLESSEY SEMICONDUCTORS LIMITED, Swindon, Wiltshire SN2 2QW (GB)
(72) Inventor: Kerr, John Anthony, Forest Park, Lincoln, LN6 0XT (GB); Garraway, Anthony Sakari, Nottinghamshire, NG24 2AT (GB)
(74) Representative: Hoste, Colin Francis

(57) **Abstract**

In order to reduce the leakage current which can occur in N-channel MOS devices formed on a sapphire substrate when subject to incident radiation, a P-type layer is formed at the interface between the substrate and the epitaxial silicon in which the MOS devices are formed. The P-type layer is produced by implanting high energy silicon ions through the epitaxial silicon to back-scatter aluminium from the sapphire interface. Subsequent annealing produces a high quality crystalline structure in the silicon. The improvement in radiation hardness is substantial.

## Description

The present invention relates to Silicon on Sapphire (SOS) integrated circuit arrangements and to methods of manufacturing such integrated circuit arrangements.

There is an increasing demand for integrated circuits which can survive the damaging effects of radiation and continue in operation. For example, electronic equipment for satellites and space probes needs to be resistant, or hard, to radiation normally screened out by the earth's atmosphere, which radiation, in the form of cosmic rays, electrons, protons and x-rays, can alter and degrade the electrical characteristics of its integrated circuits and lead to catastrophic device and system failures. Of the current silicon-based semiconductor technologies, only silicon-on-sapphire appears to offer the necessary resistance to single event upset, transient and total dose radiation.

Much effort has gone into controlling the epitaxial deposition of silicon on sapphire substrates in order to provide supplies of wafers suitable for processing into radiation-hard products, but epitaxial deposition processes optimised for some purposes can degrade the already poor crystal quality of silicon-on-sapphire, resulting in reduced carrier mobility and increased leakage. At the same time there is no reliable non-destructive test available for checking wafer quality, and the device or circuit performance attainable only becomes apparent after the completion of wafer processing. In the case of one particular epitaxial deposition process optimised for improving the radiation performance of N-channel devices subsequently formed on the substrate, the temperature of the substrate is varied during the epitaxial deposition process, and this causes aluminium from the substrate to diffuse uniformly into the silicon layer, increasing P-channel device leakage to an unacceptable extent.

According to the present invention there is provided a method of manufacturing an integrated circuit arrangement in which a plurality of N-channel devices are formed in a layer of silicon deposited on a sapphire substrate, including the steps of implanting silicon or germanium ions into the silicon layer at least over the areas to be covered by said N-channel devices with energies such that their mean range in silicon is substantially equal to the thickness of said layer of silicon to form a thin P-type region in said layer adjacent the interface between said layer and said substrate by back-scattering of aluminium atoms from said substrate into said layer of silicon, and annealing said layer, and subsequent to the aforementioned steps, removing selected regions of the layer of silicon to leave isolated islands of silicon on the sapphire substrate, some of which islands contain a said N-channel device.

The use of germanium ions is more suitable with ultra thin films of silicon, as in such a case it can provide mobility enhancement.

The annealing process may improve the crystal structure of the deposited layer of silicon by solid phase epitaxial growth. When the method defined above is to be used the epitaxial deposition conditions under which the layer of silicon is formed may be optimised for best possible crystal perfection.

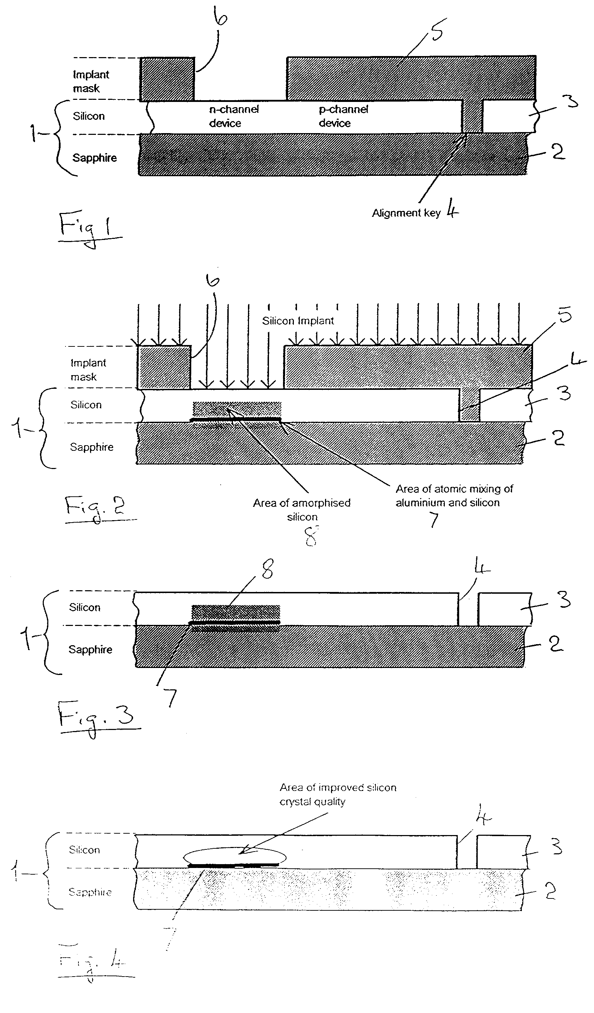

A method of manufacturing silicon-on-sapphire (SOS) integrated circuits in accordance with the invention will now be described with reference to the accompanying drawing, of which Figures 1 to 5 show schematically in cross-section part of a silicon-on-sapphire wafer at respective different stages of the method of manufacture.

Referring first to Figure 1, the method of manufacture utilises a wafer 1 comprising a sapphire substrate 2 carrying an epitaxially deposited layer 3 of silicon some 200nm thick. The silicon layer 3 has one or more apertures 4 therein, extending down to the substrate 2, which act as alignment keys during the processing of the wafer 1.

A layer 5 of resist material, which may for example be of the order of a micrometre thick, is deposited over the silicon layer 3, and apertures 6 are defined in that resist layer over the areas where N-channel devices are to be formed. Areas where P-channel devices are to be formed are masked by the resist layer 5.

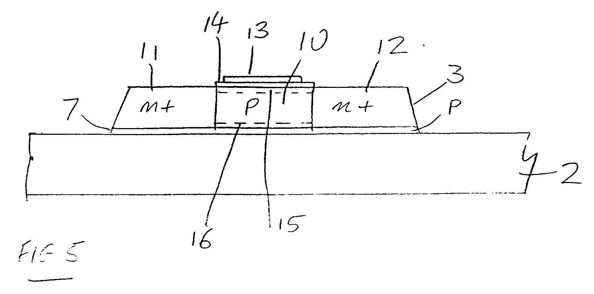

As indicated in Figure 2, the masked wafer 1 is then subjected, over the areas where N-channel devices are to be formed, to an amorphising implant of silicon ions with a mean range at or near the silicon-sapphire interface, the resist layer 5 being sufficiently thick to prevent any appreciable silicon ion penetration into the masked areas of the silicon layer 3. A beam of silicon ions of suitable energy may be generated as singly ionised ions in a 160KeV implanter, from undiluted silane SiH₄ to minimise the implantation of unwanted species such as molecular nitrogen and to reduce the implantation time required. The silicon ion dose levels may be in the range 1 x 10¹⁴ to 2 x 10¹⁵ cm⁻².

The energy of the implanted silicon ions has a very narrow spread about the mean value of 160KeV and is chosen in relation to the thickness of the silicon layer 3 such that a high proportion of the energy of the ion beam is given up at the interface between the silicon layer 3 and the sapphire substrate 2.

This has two main effects. Sapphire has the composition Al₂O₃, and the effect of the ion beam is to back-scatter aluminium atoms locally into the silicon to form a thin region 7 in which atomic mixing of the aluminium and silicon occurs, thus forming a p+type region which typically is only about 20nm thick. In addition, the action of the ion beam is to locally destroy the crystalline structure of the silicon so as to produce amorphous silicon over a region which extends over an appreciable thickness of the silicon layer 3. It is important not to amorphise the entire thickness of the layer, since a sufficiently large surface region of crystalline silicon must remain to seed the crystal regrowth which is required. As shown in Figure 3, the photoresist layer 5 is stripped off, and then this crystal regrowth is achieved by annealing the layer 3 by heating it to about 800°C for half an hour, after which it is cooled slowly as the crystalline structure reforms. At this stage, as shown in Figure 4, the crystalline quality of the silicon layer 3 is high and the p+ region of the silicon is activated. The upper regions of the layer close to its top surface may contain defects which were originally present when the epitaxial layer was first grown on the sapphire substrate. In order further to enhance the crystal quality, the entire silicon layer is subject to a further implant of silicon ions from an ion implanter, but this time with a much lower energy such that only the upper region of the layer 3 is amorphised. This leaves the enhanced quality crystalline structure below it unmodified, and this lower region is used to seed the crystal regrowth, when during the next step the structure is again annealed.

Subsequent to this step therefore one has a layer 3 of crystalline silicon on the sapphire substrate 2, in which the crystalline structure in the region in which n-channel devices are to be formed, is of exceptionally regular crystalline structure with the minimum of dislocations, and the p-type layer of aluminium is present at the interface between the sapphire and the silicon.

Subsequently the device is processed in conventional fashion to produce a pattern of p-channel and n-channel MOS devices as required, the region of silicon around each MOS being removed to leave a large plurality of separate islands mounted on the common substrate of sapphire.

One such island is shown in Figure 5, in which an n-channel MOS device has been formed. In this example, the basic epitax silicon comprises a central P-type region 10, having an n+ source region 11 on one side, and an n+ drain region 12 on the other side, and a gate electrode 13 mounted on and spaced from the central region 10 by a thin layer 14 of gate oxide.

It will be appreciated that Figure 5 is diagrammatic and does not illustrate all of the features normally associated with an MOS device, such as source and drain connections, and surface passivation layers.

By the application of a suitable potential to the gate electrode 13, an n-channel 15 is formed below the oxide layer 14 leading to electrical conduction between the source 11 and the drain 12, in well known fashion. The n-channel is so-called as it is an excess of free electrons in that region which constitutes the source-drain current. In conventional devices, such an MOS device may, in effect, be shorted out by an unwanted n-channel, or leakage path 16 which can form at the silicon-sapphire interface due to the effects of radiation which causes charge trapping.

Holes tend to be trapped at the surface of the sapphire, leading to a mirror image negative charge caused by free electrons at the lower surface of the silicon layer. This constitutes the undesirable n-channel 16. In accordance with the invention, the p-layer 7 increases the threshold voltage of the parasitic devices making it more difficult for the unwanted n-channel 16 to form, and the resulting increase in radiation tolerance can be very substantial. Typically the radiation hardness may increase from 100K Rad to well over 1M Rad tolerance, which is due not only to the presence of the p+ layer 7, but also to the enhanced crystal quality, which reduces the number of holes (positive charges) which are trapped in the lattice.

## Claims

1. A method of manufacturing an integrated circuit arrangement in which a plurality of N-channel devices are formed in a layer of silicon deposited on a sapphire substrate, including the steps of implanting silicon or germanium ions into the silicon layer at least over the areas to be covered by said N-channel devices with energies such that their mean range in silicon is substantially equal to the thickness of said layer of silicon to form a thin P-type region in said layer adjacent the interface between said layer and said substrate by back-scattering of aluminium atoms from said substrate into said layer of silicon, and annealing said layer, and subsequent to the aforementioned steps, removing selected regions of the layer of silicon to leave isolated islands of silicon on the sapphire substrate, some of which islands contain a said N-channel device.

2. A method as claimed in Claim 1 in which selected regions of the silicon layer are provided with a surface coating which is substantially impenetrable to incident silicon ions.

3. A method as claimed in Claim 2, and wherein the surface coating comprises a photoresist material.

4. A method as claimed in Claim 1, 2 or 3 and wherein the mean energy of the silicon ions is of the order of 160KeV.

5. A method as claimed in any of the preceding claims, and wherein silane is used as the source of the silicon ions.

6. A method as claimed in any of the preceding claims and wherein said layer is annealed at a temperature of the order of 800°C.

7. A method as claimed in any of the preceding claims, and wherein following said annealing step, silicon ions having a lower mean energy are implanted over at least the area to be covered by said N-channel device to produce a region of amorphous silicon extending from its exposed surface, and annealing said layer.

8. An integrated circuit arrangement including an element which is produced in accordance with any of the preceding claims.

9. A method of manufacturing an integrated circuit arrangement, substantially as illustrated in and described with reference to, the accompanying drawings.
